# EUROPEAN PATENT APPLICATION

(11) **EP 1 552 955 A1**
(43) Date of publication of application: **13.07.2005**
(21) Application number: 03808899.3
(22) Date of filing: 10.10.2003
(51) Int. Cl.: B41N 1/14

(54) **PHOTOSENSITIVE RESIN COMPOSITION FOR LITHOGRAPHIC PRINTING FORME AND ORIGINAL FORME FOR LITHOGRAPHIC PRINTING**

(30) Priority: 16.10.2002 JP 2002301656; 16.10.2002 JP 2002301191
(71) Applicant: Mitsui Chemicals, Inc., Tokyo 105-7117 (JP)
(72) Inventor: SANADA, Takayuki, Sodegaura-shi, Chiba 299-0265 (JP); KOIDE, Akihiro, Sodegaura-shi, Chiba 299-0265 (JP); SUZUKI, Yuko, Sodegaura-shi, Chiba 299-0265 (JP); TAKANO, Kouji, Sodegaura-shi, Chiba 299-0265 (JP); NAITO, Shinya, Sodegaura-shi, Chiba 299-0265 (JP)
(74) Representative: HOFFMANN - EITLE
(86) International application number: PCT/JP2003/013008
(87) International publication number: WO 2004/035319

(57) **Abstract**

It relates to a photosensitive resin composition for lithographic printing plate **characterized by** the fact that the photosensitive resin composition for lithographic printing plate comprises not less than 10 % by weight and not more than 90 % by weight of a hydrophilic polymer having at least a hydrophilic group and not less than 0.5% by weight and not more than 20 % by weight, based on the amount of the hydrophilic polymer, of a compound that inhibits hydrogen bond within the molecule and/or between the molecules of the hydrophilic polymer. The lithographic printing original plate preferable has a hydrophilic resin photosensitive layer obtained by crosslinking a photosensitive resin composition that comprises not less than 10 % by weight and not more than 90 % by weight of a hydrophilic polymer having at least a hydrophilic group and not less than 0.5% by weight and not more than 20 % by weight, based on the amount of the hydrophilic polymer, of a compound that inhibits hydrogen bond within the molecule and/or between the molecules of the hydrophilic polymer.

An original plate for CTP, which can be handled even in a bright room, is excellent in hydrophilicity, does not require operations of development and wiping-off and hardly brings about scumming even when the amount of the fountain solution is reduced, is provided.

## Description

### TECHNICAL FIELD

The present invention relates to a photosensitive resin composition for lithographic printing plate and a printing original plate, and more particularly to a photosensitive resin composition for lithographic printing plate and a lithographic printing original plate that utilizes a fountain solution. In more detail, it relates to a photosensitive resin composition for lithographic printing plate and a printing original plate, which is sensitive to a light in near infrared region, which can be handled even in a bright room, on which drawing can be directly made with a laser beam, which does not need operations of development and wiping-off and which is excellent in various printing properties.

### RELATED BACKGROUND ART

Lithographic printing, so-called offset printing, is the mainstream in the printing on paper and is widely used. Printing plates for use in the offset printing have been heretofore produced as follows: a printing original is temporarily output on paper or the like, then the original is photographed to prepare a comprehensive film, and through the comprehensive film, a photosensitive original plate is exposed and developed.

However, with recent digitization of information and increase of laser power, a process wherein drawing is directly carried out on an original plate by laser scanning to prepare a printing plate without using the comprehensive film, a so-called CTP (Computer To Plate) process, has been put into practical use in the production of printing plates.

As the plate for the CTP process practically used at present; there is a photopolymer type plate using photoreaction due to a visible light of about 500 nm. This plate, however, has problems that the plate needs development, has poor resolution and cannot be handled in a bright room.

In order to solve such problems, a lithographic printing original plate using thermal reaction due to a light of near infrared region is disclosed in Japanese Patent Laid-open Publication No.20629 (1995), and this plate has already been on the market. Although this plate can be certainly handled in a bright room and has excellent resolution, it still needs a process of development.

As a lithographic printing original plate that does not require a wet development process, a plate, in which self-dispersive resin particles are melted and fusion bonded to form an image in the exposed area, is disclosed in Japanese Patent Laid-Open Publication No.127683 (1997). The non-image area of the photosensitive layer of these plates can be removed using a fountain solution, so that development can be carried out on a printing press and an exclusive developing machine is unnecessary. In the on-press development, however, there are problems that the fountain solution and the ink are contaminated and, when preserving the plate, strict control of the moisture is required.

As a plate for lithographic printing that needs neither wet development nor on-press development, an original plate having a hydrophilic resin layer containing hydrophobic thermoplastic resin particles that are independent from one another and in contact with one another, wherein the hydrophobic polymer particles are fusion bonded by heat to change the hydrophilicity of the resin layer, is disclosed in U.S.Pat.No.3,476,937. However, when drawing is made on the plate by irradiation with a light, the sensitivity is low and the hydrophilic resin layer has low mechanical strength, which makes the durability of the plate poor. Moreover, if the amount of the hydrophobic thermoplastic polymer has been increased to improve the ink receptivity, there is a disadvantage that scumming easily takes place.

Furthermore, in Japanese Patent Laid-Open Publication No.314934(1995), a plate having such a structure that an ink-repellent layer made of a silicone resin is laminated on an inorganic light absorbing layer comprising titanium, titanium oxide or so on is disclosed, and the plate has been developed and on the market. In this plate, the silicone resin layer repels ink and becomes a non-image area, while an image area is formed by irradiation with a near infrared light. However, the silicone resin layer in the irradiation area can not be removed only by the irradiation with the light, and wiping-off to remove the silicone resin layer is necessary in the printing process. If the wiping-off of the silicone resin is insufficient, ink is insufficiently received on the irradiated area to cause defects in the image area, and printing is not made satisfactorily.

In view of the above, the inventors have disclosed a lithographic printing original plate comprising a hydrophilic resin photosensitive layer prepared by crosslinking a photosensitive resin composition comprising a hydrophilic polymer, a crosslinking agent and a light absorbing agent or a photosensitive resin composition comprising a hydrophilic polymer, a crosslinking agent, a light absorbing compound and a hydrophobic polymer and can be converted from hydrophilic to ink-receptive by irradiation with a light in WO/01/83234. The original plate does not require development or wiping-off and has an excellent sensitivity and resolution, since only the surface of the irradiated area changes. In order to improve the properties of the plate, it is desired to improve the water retention of the hydrophilic layer.

### DISCLOSURE OF THE INVENTION

It is an object of the present invention to provide a photosensitive resin composition for CTP and an original plate for CTP that can be handled even in a bright room, can dispense with steps of development and wiping-off, is excellent in hydrophilicity and hardly exhibit scumming even when the amount of the fountain solution is reduced.

The inventors have conducted an intensive research and found that the above object can be accomplished by making the composition comprising a hydrophilic polymer contain an appropriate amount of a compound that can inhibit hydrogen bond within the hydrophilic polymer and/or between the hydrophilic polymers and crosslinking the photosensitive resin composition to form a hydrophilic resin photosensitive layer, and thereby accomplished the present invention.

The present Inventions are as follows.
1) A photosensitive resin composition for lithographic printing plate characterized by the fact that the photosensitive resin composition for lithographic printing plate comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound that inhibits hydrogen bond within the molecule and/or between the molecules of the hydrophilic polymer.
2) A photosensitive resin composition for lithographic printing plate characterized by the fact that the photosensitive resin composition for lithographic printing plate comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound represented by the general formula (1) . 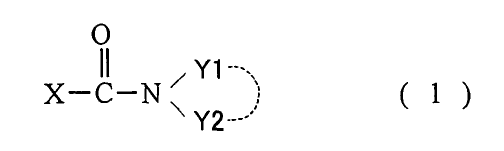 (In the formula, X represents CHR1=CR2- or N(R3) (R4); each of R1, R2, R3 and R4 independently represents hydrogen atom, an alkyl group, an alkoxy group, an aryl group or a heterocyclic group. Y1 and Y2 respectively represent hydrogen atom, an alkyl group, an alkoxy group or an aryl group, Y1 and Y2 can be taken together to form a ring with the nitrogen atom and the ring can contain hetero atoms.)
3) A lithographic printing original plate utilizing a fountain solution and comprising a hydrophilic photosensitive layer characterized by the fact that the hydrophilic photosensitive layer is obtained from a photosensitive resin composition for lithographic printing plate that comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound represented by the general formula (1). 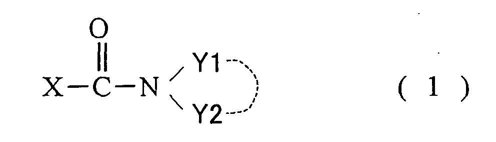 (In the formula, X represents CHR1=CR2- or N(R3)(R4); each of R1, R2, R3 and R4 independently represents hydrogen atom, an alkyl group, an alkoxy group, an aryl group or a heterocyclic group. Y1 and Y2 respectively represent hydrogen atom, an alkyl group, an alkoxy group or an aryl group, Y1 and Y2 can be taken together to form a ring with the nitrogen atom and the ring can contain hetero atoms.)
4) A lithographic printing plate obtained by irradiating a light on the lithographic printing original plate described in 3) and thereby converting the surface of the irradiated area to ink-receptive.
5) A lithographic printing original plate utilizing fountain solution and having a hydrophilic resin photosensitive layer, wherein the hydrophilic resin photosensitive layer is obtained from a photosensitive resin composition for lithographic printing plate that comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound that inhibits hydrogen bond within the molecule and/or between the molecules of the hydrophilic polymer.

If the lithographic printing original plate of the present invention is used, it is possible to provide a lithographic printing plate that does not require processes such as development and wiping-off, is excellent in hydrophilicity and is free of scumming.

### BEST MODES FOR CARRYING OUT THE INVENTION

The present invention will be explained below in detail.

The first embodiment of the present invention is a photosensitive resin composition for lithographic printing plate characterized by the fact that the photosensitive resin composition for lithographic printing plate comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound that inhibits hydrogen bond within the molecule and/or between the molecules of the hydrophilic polymer.

No limitation is imposed on the photosensitive resin composition for lithographic printing plate of the present invention as far as the above requirements are fulfilled. The composition can be used in both development type and non-development type lithographic printing.

In the present invention, it is the characteristic that an appropriate amount of the compound that inhibits hydrogen bond within the molecule and/or between the molecules of the hydrophilic polymer is contained in the photosensitive resin compound. By containing an appropriate amount of the compound, the hydrophilicity of the photosensitive layer is improved. In particular, it is preferable to contain not less than 0.5% by weight and not more than 20% by weight of the compound, based on the amount of the hydrophilic polymer, in a photosensitive resin composition comprising not less than 10% by weight and not more than 90% by weight, preferably not less than 20% by weight and not more than 80% by weight, of hydrophilic polymer. More preferably, not less than 1% by weight and not more than 15% by weight of the compound is contained. The above-mentioned "based on the amount of the hydrophilic polymer" means that the sum of the weight of the hydrophilic polymer and the weight of the compound is considered to be 100% by weight. If the compound is copolymerized in the hydrophilic polymer, the percentage indicates the amount of the compound that exists in the copolymerized hydrophilic polymer. When the hydrophilic polymer exists in an amount within the range described above in the photosensitive resin composition, it is possible to balance the hydrophilicity with the water resistance and the durability. Furthermore, when the amount of the compound that can inhibit hydrogen bond within the molecule and/or between the molecules of the hydrophilic polymer is within the range described above, the hydrophilicity of the hydrophilic polymer is significantly improved and the possibility of the occurrence of the problems such as deterioration of durability is low. In the present invention, no particular limitation is imposed on the type of the compound that can inhibit hydrogen bond within the molecule and/or between the molecules of the hydrophilic polymer, as far as it has a compatibility with the hydrophilic polymer and inhibits hydrogen bond within the molecule and/or between the molecules of the hydrophilic polymer. Concrete examples of the compound include methyl (meth)acrylate, N-vinylformamide, acetaldehyde, guanidine and vinyl acetate. Preferably, the compound is a compound represented by the following general formula (1). 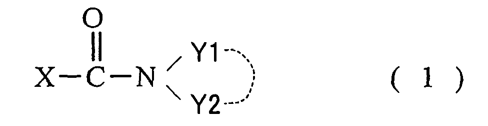 (In the formula, X represents CHR1=CR2- or N(R3) (R4), each of R1, R2, R3 and R4 independently represents hydrogen atom, an alkyl group, an alkoxy group, an aryl group or a heterocyclic group. Y1 and Y2 respectively represent hydrogen atom, an alkyl group, an alkoxy group or an aryl group, Y1 and Y2 can be taken together to form a ring with the nitrogen atom and the ring can contain hetero atoms.)

In the general formula (1), each of R1, R2, R3 and R4, which may constitute X in the general formula (1), independently represents hydrogen atom, an alkyl group, an alkoxy group, an aryl group or a heterocyclic group. Their concrete examples include alkyl groups such as methyl group, ethyl group and isopropyl group; alkoxy groups such as methoxy group and ethoxy group; aryl groups such as phenyl group, tolyl group and carbazole group; and heterocyclic groups such as pyridyl group, pyrrole group and thiophenyl group. These groups can contain a functional group such as allyl group, an ether group, carboxy group or carbamoyl group. Each of R1, R2, R3 and R4 preferably is an alkyl group, an alkoxy group or a hydrogen atom. Also, Y1 and Y2 respectively represent hydrogen atom, an alkyl group, an alkoxy group or an aryl group. Concrete examples of them include alkyl groups such as methyl group, ethyl group and isopropyl group; alkoxy groups such as methoxy group and ethoxy group; and aryl groups such as phenyl group, tolyl group and carbazole group. Furthermore, Y1 and Y2 can be taken together to form a ring with the nitrogen atom and the ring can contain hetero atoms. More concretely, Y1 and Y2 can be methyl group or isopropyl group respectively, or may form morpholino group or piperidino group. Preferably, dimethyl group and morpholino group can be cited.

More preferably, the compound represented by the general formula (1) is an N, N-disubstituted (meth) acrylamide compound or urea. Preferable examples of the N,N-disubstituted (meth)acrylamide compound include N,N-dimethyl (meth)acrylamide, (meth)acryloyl morpholine and so on.

As the process for getting the compound contained in the composition, the compound can be added in the photosensitive resin composition, or it can be contained in the hydrophilic polymer by copolymerizing with the hydrophilic polymer. If an N,N-disubstituted (meth) acrylamide compound is to be contained, the latter is more preferable.

In the photosensitive resin composition containing these, when dye was added as a photo-thermal converter, dispersibility of the dye is improved, coagulates of the dye in the photosensitive layer decrease and then the productivity is improved. The compatibility of the dye and the hydrophilic polymer seems to be improved as a result of the inhibition on hydrogen bond within the molecule and between the molecules of the hydrophilic polymer. The homogeneous dispersion of the dye is considered to be one of the reasons of the improvement of the hydrophilicity.

A lithographic printing original plate, which is the second embodiment of the present invention, will be explained below in detail.

In the lithographic printing original plate of the present invention, a photosensitive layer made of a hydrophilic polymer that is insoluble in water is formed on a substrate. Concrete Examples of the substrates used herein include metallic plates, such as aluminum plate, steel plate, stainless steel plate and copper plate, plastic films, such as films of polyester, nylon, polyethylene, polypropylene, polycarbonate and ABS resin, paper, aluminum foil laminated paper, metal deposited paper, and plastic film laminated paper. Although there is no specific limitation on the thickness of the substrate, the thickness is usually in the range of from 100 to 400 µm. In order to improve the adhesion properties, these substrates can be subjected to surface treatment, such as oxidation treatment, chromate treatment, sandblasting treatment and corona discharge treatment.

Next, the photosensitive layer of the present invention, which comprises a hydrophilic polymer that is insoluble in water, is described in detail. The lithographic printing plate of the invention is a printing plate for offset printing using a fountain solution, preferably is a non-development type plate. In a non-development type plate, the area other than the irradiated area of its photosensitive layer becomes a non-image area. Therefore, in this case, the photosensitive layer of the present invention needs to be hydrophilic and insoluble in water. In the plate of the present invention, the light irradiated area of the photosensitive layer changes it hydrophilicity from hydrophilic to ink-receptive without being removed by ablation. Hence, the printing plate of the present invention does not need operations of development or wiping-off after the irradiation with a light. In order to embody the above-mentioned property change, the photosensitive layer of the invention is prepared by crosslinking a hydrophilic polymer, preferably a photosensitive composition further comprising a crosslinking agent and a light absorbing agent, more preferably a photosensitive composition comprising a hydrophilic polymer, a crosslinking agent, a hydrophobic polymer and a light absorbing agent. By the crosslinking, the hydrophilic polymer becomes water-insoluble. In a development type plate, wherein the photosensitive resin composition is coated on a hydrophilic surface, the photosensitive layer in an unexposed area is removed by development and thus the underlying hydrophilic surface is exposed outside. Therefore, it is not necessary to make the photosensitive resin composition insoluble in a development type plate. From the viewpoint of the ease in handling, fluctuations in printing qualities and costs in printing processes, a non-development type plate is more preferable.

The hydrophilic polymer used for the photosensitive resin composition for lithographic printing plate of the present invention is a polymer that has at least a hydrophilic group and shows hydrophilicity. It preferably is a polymer having a hydrophilic group and a functional group that is reactive with a crosslinking agent (crosslinking functional group). Examples of the hydrophilic group of the hydrophilic polymer include hydroxy group, amido groups, amino group, sulfonamide groups, oxymethylene group, and oxyethylene group. Furthermore the examples include acidic groups such as carboxy group, sulfonic group and phosphonic group and alkali metal salts and amine salts of the acidic groups.

Examples of the crosslinking functional group include hydroxy group, amido groups, amino group, isocyanate group, glycidyl group, oxazoline group, methylol group, and groups such as methoxymethyl group and butoxymethyl group, which and obtainable by condensing methylol group with an alcohol such as methanol and butanol. Furthermore, the examples include acidic groups such as carboxy group, sulfonic group and phosphonic group and alkali metal salts, alkaline earth metal salts and amine salts of the acidic groups.

More concrete examples of the hydrophilic polymer include the following water-soluble polymers. Namely, celluloses, gelatins, polymers obtained by polymerization or copolymerization of unsaturated acids having the aforesaid hydrophilic groups or crosslinking functional groups, their derivatives, N-vinylacetamide, N-vinylformamide, vinyl acetate, vinyl ether, and so on and polymers obtained by hydrolysis of these polymers can be cited. Among these, preferable are polymers obtained by polymerizing unsaturated acids having the aforesaid hydrophilic groups or the crosslinking functional groups, their derivatives, N-vinylacetamide or N-vinylformamide as the main component, from the viewpoints of the ease of crosslinking, the ease of achieving the balance between hydrophilicity and water-resisting qualities and the ease of obtaining ink receptivity by irradiation with a light.

Concrete examples of the unsaturated acids having the aforesaid hydrophilic groups or the crosslinking functional groups and their derivatives include hydroxyethyl (meth)acrylate, polyethylene glycol mono(meth)acrylate, hydroxypropyl (meth)acrylate, polypropylene glycol mono(meth)acrylate, hydroxybutyl (meth)acrylate and methylol (meth)acrylamide, and condensation products of the said methylol (meth) acrylamide and methyl alcohol or butyl alcohol, such as methoxymethyl (meth)acrylamide or butoxymethyl (meth)acrylamide, as unsaturated acid derivatives having a hydroxy group.

Examples of the unsaturated acid derivative having an amido group include unsubstituted or substituted (meth) acrylamides, unsubstituted or substituted itaconic acid amides, unsubstituted or substituted fumaric acid amides, unsubstituted or substituted phthalic acid amides, N-vinylacetamide and N-vinylformamide. More concrete examples of the unsubstituted or substituted (meth) acrylamides include (meth)acrylamide, N-methyl (meth)acrylamide, N-ethyl (meth)acrylamide, N-isopropyl (meth)acrylamide, diacetone (meth)acrylamide, methylol (meth)acrylamide, methoxymethyl (meth)acrylamide, butoxymethyl (meth)acrylamide, propyl sulfonate (meth)acrylamide and so on. The dibasic acid amide such as itaconic acid amide mentioned above may be a monoamide, which is obtained by the amidation of one carboxy group, or a diamide, which is obtained by the amidation of both carboxy groups. Examples of the unsaturated acid derivatives having glycidyl group include glycidyl (meth)acrylate, paravinylphenyl glycidyl ether and so on.

Examples of the unsaturated acid having carboxyl group include monobasic unsaturated acids, such as (meth) acrylic acid; dibasic unsaturated acids, such as itaconic acid, fumaric acid and maleic acid and anhydrides thereof; and monoesters and monoamides of these dibasic unsaturated acids.

Examples of the unsaturated acids having a sulfonic group include sulfoethyl (meth)acrylate, (meth)acrylamide methylpropane sulfonic acid, vinylsulfonic acid, vinylmethylsulfonic acid, isopropenylmethylsulfonic acid, sulfuric esters of an alcohol obtained by addition of ethylene oxide or propylene oxide to (meth)acrylic acid (e.g., ELEMINOL™ RS-30 available from Sanyo Kasei Kogyo K.K.), (meth)acryloyloxyethylsulfonic acid, esters of a monoalkylsulfosuccinate[sic] and a compound having allyl group, reaction products of a monoalkylsulfosuccinate and glycidyl (meth)acrylate and so on. Examples of the polymerizable unsaturated monomer having a phosphoric group include vinylphosphoric acid, mono(2-hydroxyethyl) phosphate (meth)acrylate, mono(2-hydroxyethyl)(meth)acrylate of a monoalkyl phosphate and so on. The carboxyl groups, the sulfonic groups and the phosphoric groups may be neutralized with an alkali metal, an alkaline earth metal or an amine. Examples of the alkali metal used for neutralization include sodium, potassium, lithium and so on. Examples of the alkaline earth metal include calcium, magnesium and so on. Examples of the amine include ammonia, methylamine, dimethylamine, trimethylamine, ethylamine, diethylamine, triethylamine, monoethanolamine, diethanolamine, triethanolamine and so on.

In the polymerization, a monomer copolymerizable with the unsaturated acid or the derivative thereof may also be used. Examples of the copolymerizable monomer include methyl (meth)acrylate, ethyl (meth)acrylate, butyl (meth)acrylate, 2-ethylhexyl (meth)acrylate, glycidyl (meth)acrylate, dimethylaminoethyl (meth)acrylate, diethylaminoethyl (meth)acrylate, phenoxyethyl (meth)acrylate, benzyl (meth)acrylate, , adamantyl (meth)acrylate, cyclohexyl (meth)acrylate, styrene, α-methylstyrene, acrylonitrile, methacrylonitrile and vinyl acetate.

In this specification, terms "(meth)acryl" in such as "(meth)acrylamides" and "(meth)acrylic acids", "(meth)acryloyl" , "(meth)acrylate" and so on mean both of acryl and methacryl, both of acryloyl and methacryloyl, and both of acrylate and methacrylate, respectively.

In the photosensitive resin composition for lithographic printing plate of the invention, a crosslinking agent is preferably used to crosslink the hydrophilic polymer. The crosslinking agent has only to be one that undergoes crosslinking reaction with the hydrophilic polymer to make the hydrophilic polymer water-insoluble and thereby improve the durability of the hydrophilic resin photosensitive layer. Examples of the crosslinking agent include publicly known polyhydric alcohol compounds, polycarboxylic acid compounds and anhydrides thereof, polyglycidyl compounds, polyamines, polyisocyanate compounds, block isocyanate compounds, epoxy resins, oxazoline resins, amino resins and so on that can react with the crosslinking functional group in the hydrophilic polymer such as hydroxyl group, carboxy group, sulfonic group or glycidyl group, or in some cases, an amido group.

Among the above-mentioned crosslinking agents, publicly known various aqueous epoxy resins, publicly known oxazoline resins, publicly known amino resins and aqueous block isocyanate compounds are preferably used in the invention, from the viewpoints of the curing rate, the stability of the photosensitive resin composition at room temperature, and the balance between the hydrophilicity and the durability of the photosensitive layer. Examples of the amino resin include publicly known melamine resins, urea resins, benzoguanamine resins, glycoluril resins, and modified resins of these resins, such as carboxy-modified melamine resins. In the use of the said epoxy resin, tertiary amines may be used in combination, and in the use of the amino resin, acidic compounds such as paratoluenesulfonic acid, alkylbenzenesulfonic acids or ammonium chlorides may be used in combination, in order to promote the crosslinking reaction.

Although the main role of the said crosslinking agent is to crosslink the said hydrophilic polymer to make the hydrophilic polymer insoluble in water, in case that the crosslinking agent is self-polymerizable, the agent also has a role to change the light irradiated area of the surface from hydrophilic to ink-receptive, wherein the crosslinking agent forms an island phase in the hydrophilic polymer in the photosensitive layer, the light absorbing agent in the photosensitive layer absorbs the light and convert the photo energy to thermal energy, and the island phase generates foam by the thermal energy generated, and then the surface is changed.

In the photosensitive resin composition for the lithographic printing plate of the present invention, a hydrophobic polymer is preferably used to make it easier to change the surface of the irradiated area from hydrophilic to ink-receptive by the light irradiation.

As the hydrophobic polymer, an aqueous dispersion hydrophobic polymer having an average particle diameter measured by dynamic light scattering method of from 0.005 to 0.5 µm, more preferably from 0.01 to 0.2 µm, is preferable from the viewpoints of the sensitivity of the printing plate and the ease of converting the plate to ink-receptive when a light is irradiated.

The aqueous dispersion hydrophobic polymer means a hydrophobic polymer, in which particles comprising fine polymer particles and if necessary a protecting agent covering the particles, are dispersed in an aqueous solvent, and is, for example, a polymer, wherein a hydrophobic polymer prepared by emulsion polymerization or suspension polymerization of an unsaturated monomer, in particular a hydrophobic polymer having an acidic group, or an organic solvent solution of the polymer is dispersed in water, optionally by neutralizing the acidic group or adding a dispersion stabilizer as needed, or a polymer obtained by distilling off the organic solvent from the polymer as needed. Concrete examples of the aqueous dispersion hydrophobic polymer include vinyl polymer lateces, conjugated diene polymer lateces, acrylic lateces, aqueous dispersion polyurethane resins, aqueous dispersion epoxy resins and so on.

It is considered to be a role of the hydrophobic polymer described above that the hydrophobic polymer forms an island phase in the hydrophilic polymer in the photosensitive layer, the hydrophobic polymer in the island phase thermally melts and fusion bonds by the thermal energy generated when the light absorbing agent in the photosensitive layer absorbs the light to convert the photo-energy to thermal energy, and then the light irradiated area of the surface is changed from hydrophilic to ink-receptive. The average particle diameter of the hydrophobic polymer is preferably from 0.005 to 0.5 µm as described above, and is more preferably from 0.01 to 0.4 µm, in order to efficiently change the surface to ink-receptive by the melting and the fusion bonding. When the diameter is within the range, the hydrophobic polymer melts and fusion bonds easily by the heat generated, the sensitivity is excellent and the hydrophilicity of the photosensitive layer does not deteriorate.

When the hydrophobic polymer described above is used in the photosensitive layer of the present invention, although the amount of the dispersed hydrophobic polymer phase is preferably large from the viewpoint of ink receptivity of the light irradiated area, excessive amount of the polymer is unfavorable because scumming takes place. From this viewpoint, the amount of the hydrophobic polymer in the photosensitive resin composition of the present invention is preferably 80% by weight or less, more preferably 70% by weight or less, further preferably 60% or less, in terms of solid component.

In a preferred embodiment of the present invention, a light absorbing agent can be further used in the photosensitive resin composition for lithographic printing plate. The light absorbing agent has only to be one that absorbs a light to generate heat. In the irradiation step, a light in the wavelength region capable of being absorbed by the light absorbing compound is appropriately used. Examples of the light absorbing compound include dyes such as cyanine dyes, polymethine dyes, phthalocyanine dyes, naphthalocyanine dyes, anthracyanine dyes, porphyrin dyes, azo dyes, benzoquinone dyes, naphthoquinone dyes, dithiol metal complexes, diamine metal complexes and nigrosine, and carbon black.

Among these dyes, a dye that absorbs a light in the region of from 750 to 1100 nm is preferable from the viewpoints of handling in a bright room, power of light sources used in the exposure machine, and ease of use. The absorption wavelength region of the dye can be changed depending on the types of substituents or the length of conjugated system of n electrons. The light absorbing agent may be dissolved or dispersed in an aqueous solution comprising the photosensitive resin composition. Among the light absorbing agents described above, hydrophilic light absorbing agents are preferable in the present invention. More concretely, cyanine dyes are preferable from the viewpoints of the absorption wavelength and the hydrophilicity of the light absorbing agent.

Furthermore, various types of surfactants are preferably added in the photosensitive resin composition for lithographic printing plate of the present invention in order to widen the stabile conditions in printing. Examples of the surfactant above include anionic surfactants, cationic surfactants, nonionic surfactants and amphoteric surfactants. In order to improve the coatability of the aqueous solution of the photosensitive resin composition, additives such as repelling inhibitor or leveling agent can also be added.

For forming the photosensitive layer comprising a water-insoluble hydrophilic resin of the present invention, a substrate is coated with a solution comprising a photosensitive resin composition, which comprises a hydrophilic polymer, a crosslinking agent and a light absorbing agent, preferably with a solution comprising a photosensitive resin composition, which comprises a hydrophilic polymer, a crosslinking agent, a light absorbing agent and a hydrophobic polymer, and then the solution is dried and cured. Although the coating method varies depending on the viscosity of the coating solution, the coating rate and so on, usually used are, for example, a roll coater, a blade coater, a gravure coater, a curtain flow coater, a die coater and spraying. After the application of the coating solution, the solution is heated to dry and to crosslink the hydrophilic polymer. The heating temperature is usually about 50 to 200°C. Although there is no specific limitation on the thickness of the photosensitive layer, it is usually desired to be about 0.5 to 10µm.

The printing original plate of the invention can be subjected to calendering after the photosensitive layer comprising the hydrophilic resin is formed, or a film may be laminated onto the photosensitive layer to protect the layer.

When the printing original plate of the invention is irradiated with a light in a wavelength region that can be absorbed by the light absorbing agent such as a light of from 750 to 1100 nm, the light absorbing compound absorbs the light to generate heat. By the heat generation, the light irradiated area of the photosensitive layer loses hydrophilicity and is changed to ink-receptive owing to the foaming of the self-polymerized crosslinking agent or the thermal fusion bonding of the hydrophobic polymer. If the irradiation dose is excessive or the amount of the light absorbing compound used is excessive in the process, the photosensitive layer is removed or melted off by decomposition or combustion, and the decomposition product is scattered around the irradiated area. Therefore, such excessiveness should be avoided.

As described above, in the lithographic printing original plate of the invention, the property of the light irradiated area of the photosensitive layer is changed from hydrophilic to ink-receptive, and ink adheres to the light irradiated area even if the operation of development or wiping-off are not conducted, whereby printing becomes practicable.

There is no specific limitation on the wavelength of a light used for the irradiation on the lithographic printing original plate of the present invention, and any light coincident with the absorption wavelength region of the light absorbing compound is employable. For the exposure, high-speed scanning with a focused light is preferable from the viewpoint of irradiation rate. A light source that is easily handled and has high power is suitable. From these viewpoints, a laser beam, in particular a laser beam having an oscillation wavelength in the region of from 750 to 1100 nm, is preferable as the light for irradiation. For example, a high-power semiconductor laser of 830 nm or a YAG laser of 1064 nm is preferably employed. An exposure machine equipped with such a laser has been already on the market as a so-called thermal plate setter (exposure machine).

### EXAMPLES

### Example 1

### (Synthesis of Hydrophilic Polymer P-1)

In a 1000 cc flask, 400 g of water was charged, and nitrogen was bubbled in to remove the dissolved oxygen, followed by raising the temperature to 80°C. While nitrogen gas was fed into the flask, a monomer solution consisting of 90.3 g of acrylamide, 11.3 g of N-vinylformamide, 18.4g of hydroxyethyl methacrylate and 130 g of water and an initiator aqueous solution in which 1.0 g of potassium persulfate was dissolved in 100 g of water were independently dropwise added to the flask continuously over a period of 2 hr with maintaining the internal temperature at 80°C. After the dropwise addition was completed, polymerization was continued for 3 hours at 80°C. Finally, 50 g of water was added to obtain a 15% aqueous solution of hydrophilic polymer P-1.

### (Preparation of Lithographic Printing Original Plate)

A polyester film having a thickness of 0.2 mm was coated with an aqueous solution comprising the photosensitive' resin composition, which has a composition described below (units: part(s) by weight or wt%, and so forth), using a doctor blade. Then the composition was dried at 120°C for 30 min to form a photosensitive layer having a thickness of 2 µm, whereby a lithographic printing original plate was prepared (acryloyl morpholine: 15% based on the amount of the hydrophilic polymer, hydrophilic polymer: 52% based on the amount of the photosensitive resin composition).

| | |
|---|---|
| The aqueous solution of hydrophilic polymer P-1 described above (solid content: 15%) | 400 parts |
| Methyl melamine resin (manufactured by Mitsui Cytec LTD., CYMEL™385, solid content: 80%) | 50 parts |
| Aqueous solution of cyanine dye (manufactured by Japan Photosensitive Dye Lab. Inc., IR-125, solid content: 5%) | 100 parts |
| Anionic surfactant (manufactured by Dai-ichi Kogyo Seiyaku K.K., NEOCOL™YSK, solid content: 70%) | 0.15 parts |
| Acryloyl morpholine | 10.5% |

### (Recording of Image)

The original plate was scanning-irradiated with a semiconductor laser beam having a wavelength of 830 nm with focusing the beam so that the irradiation energy density became 350 mJ/cm², whereby recording of image information of 200 lines/inch was carried out.

### (Printing and Evaluation)

The exposed plate was set in an offset printing press (manufactured by Mitsubishi Heavy Industries, Ltd., DAIYA 1F-4), and printing was carried out using a 2% aqueous solution of Astromark 3 etching solution(manufactured by Nikken Chemical Laboratory Co.,Ltd.) as a fountain solution and HY-ECO™ SOY (manufactured by Toyo Ink Mfg. Co., Ltd) as an ink. As a result, even when the amount of the fountain solution was reduced to 50% of the capacity of the printing press, which is an amount similar to that for PS plates, no ink was received on the unirradiated area at all, while an ink was received on the irradiated area sufficiently and the recorded image was reproduced on the printing paper. Even after printing of 5,000 sheets was carried out, no ink was received on the unirradiated area at all, and ink receptivity on the irradiated area did not deteriorate.

### Example 2

A lithographic printing original plate was prepared and recording of image, printing and evaluation were carried out in the same manner as in Example 1, except that the acryloyl morpholine in Example 1 was replaced with an aqueous solution of urea (solid component: 15%). (urea: 15% based on the amount of the hydrophilic polymer, hydrophilic polymer: 52% based on the amount of the photosensitive resin composition). Even when the amount of the fountain solution was reduced to 50% of the capacity of the printing press, which is an amount similar to that for PS plates, no ink was received on the unirradiated area at all, while an ink was received on the irradiated area sufficiently and the recorded image was reproduced on the printing paper. Even after printing of 5, 000 sheets was carried out, no ink was received on the unirradiated area at all, and ink receptivity on the irradiated area did not deteriorate.

### Example 3

### (Synthesis of Hydrophilic Polymer P-2)

In a 1000 cc flask, 500 g of water was charged, and nitrogen was bubbled in to remove the dissolved oxygen, followed by raising the temperature to 80°C. While nitrogen gas was fed into the flask, a monomer solution consisting of 137.1 g of acrylamide, 7.9 g of Acryloyl morpholine, 5g of 2-hydroxyethyl acrylate, 150 g of water and 0.3g of sodium phosphinate and an initiator aqueous solution in which 1.5 g of potassium persulfate was dissolved in 100 g of water were independently dropwise added to the flask continuously over a period of 2 hours with maintaining the internal temperature at 80°C. After the dropwise addition was completed, polymerization was continued for 3 hours at 80°C. Finally, 100 g of water was added to obtain a 15% aqueous solution of hydrophilic polymer P-2. (Acryloyl morpholine: 5.3% based on the amount of the hydrophilic polymer.)

### (Preparation of Lithographic Printing Original Plate)

A polyester film having a thickness of 0.2 mm was coated with an aqueous solution comprising the photosensitive composition, which has a composition described below (units: part (s) by weight or wt%, and so forth), using a doctor blade. Then the composition was dried at 120°C for 15 min to form a photosensitive layer having a thickness of 2 µm, whereby a lithographic printing original plate was prepared (hydrophilic polymer: 57% based on the amount of the photosensitive resin composition).

| | |
|---|---|
| The aqueous solution of hydrophilic polymer P-2 described above (solid content: 15%, acryloyl morpholine 5.3% based on the amount of the hydrophilic polymer) | 400 parts |
| Methyl melamine resin (manufactured by Mitsui Cytec LTD., CYMEL™701, solid content: 82%) | 49 parts |
| cyanine dye (manufactured by Japan Photosensitive Dye Lab. Inc., IR-125, solid content: 5%) | 100 parts |
| Anionic surfactant (manufactured by Dai-ichi Kogyo Seiyaku K.K., NEOCOL™YSK, solid content: 70%) | 0.14 parts |

### (Recording of Image)

The original plate was scanning-irradiated with a semiconductor laser beam having a wavelength of 830 nm with focusing the beam so that the irradiation energy density became 350 mJ/cm², whereby recording of image information of 200 lines/inch was carried out.

### (Printing and Evaluation)

The exposed plate was set in an offset printing press (manufactured by Mitsubishi Heavy Industries, Ltd., Diamond 1F-4), which utilizes a fountain solution, and printing was carried out using a 2% aqueous solution of Astromark 3 etching solution (manufactured by Nikken Chemical Laboratory Co., Ltd.) as a fountain solution and HY-ECO™ SOY (manufactured by Toyo Ink Mfg. Co.,Ltd) as an ink. As a result, even when the amount of the fountain solution was reduced to 50% of the capacity of the printing press, which is an amount similar to that for PS plates, no ink was received on the unirradiated area at all, while an ink was received on the irradiated area sufficiently and the recorded image was reproduced on the printing paper. Even after printing of 5, 000 sheets was carried out, no ink was received on the unirradiated area at all, and ink receptivity on the irradiated area did not deteriorate.

### Example 4

A lithographic printing original plate was prepared and recording of image, printing and evaluation were carried out in the same manner as in Example 3, except that the polyester film substrate of example 3 is replaced with an aluminum sheet having a thickness of 0.3 mm, on which a urethane resin (manufactured by Dai-ichi Kogyo Seiyaku K.K., SUPERFLEX™410) having a thickness of 1 µm was coated in advance as a primer to improve adhesion properties. Even when the amount of the fountain solution was reduced to an amount similar to that for PS plates, no ink was received on the unirradiated area at all, while an ink was received on the irradiated area sufficiently and the recorded image was reproduced on the printing paper. Even after printing of 10,000 sheets was carried out, no ink was received on the unirradiated area at all, and ink receptivity on the irradiated area did not deteriorate.

### Example 5

A lithographic printing original plate was prepared in the same manner as in Example 3, except that the compositions of the photosensitive resin composition of Example 3 was changed as follows. (hydrophilic polymer: 36% based on the amount of the photosensitive resin composition)

| | |
|---|---|
| The aqueous solution of hydrophilic polymer P-2 described above (solid content: 15%, acryloyl morpholine : 5.3% based on the amount of the hydrophilic polymer) | 270 parts |
| Methyl melamine resin (manufactured by Mitsui Cytec LTD., CYMEL™385, solid content: 800) | 13 parts |
| Aqueous dispersion urethane resin (manufactured by Dai-ichi Kogyo Seiyaku K.K., SUPERFLEX™410, solid content: 40%) | 125 parts |
| Cyanine dye (manufactured by Japan Photosensitive Dye Lab. Inc., IR-125, solid content: 5%) | 200 parts |
| Anionic surfactant (manufactured by Dai-ichi Kogyo Seiyaku K.K., NEOCOL™YSK, solid content: 70%) | 0.14 parts |

The original plate was scanning-irradiated with a semiconductor laser beam having a wavelength of 830 nm with focusing the beam so that the irradiation energy density became 200 mJ/cm², whereby recording of image information of 200 lines/inch was carried out. As a result of the evaluation, even when the amount of the fountain solution was reduced to an amount similar to that for PS plates, no ink was received on the unirradiated area at all, while an ink was received on the irradiated area sufficiently and the recorded image was reproduced on the printing paper.

### Example 6

A lithographic printing original plate was prepared and recording of image, printing and evaluation were carried out in the same manner as in Example 5, except that the amount of acryloyl morpholine in the hydrophilic polymer P-2 of Example 5 is changed to 1.5g (acryloyl morpholine: 1% based on the amount of the hydrophilic polymer, hydrophilic polymer: 36% based on the amount of the photosensitive resin composition) . Even when the amount of the fountain solution was reduced to an amount similar to that for PS plates, no ink was received on the unirradiated area at all, while an ink was received on the irradiated area sufficiently and the recorded image was reproduced on the printing paper.

### Example 7

A lithographic printing original plate was prepared and recording of image, printing and evaluation were carried out in the same manner as in Example 5, except that the acryloyl morpholine in the hydrophilic polymer of Example 5 is replaced with N,N-dimethyl methacrylamide (dimethyl methacrylamide: 5.3% based on the amount of the hydrophilic polymer, hydrophilic polymer: 36% based on the amount of the photosensitive resin composition). Even when the amount of the fountain solution was reduced to an amount similar to that for PS plates, no ink was received on the unirradiated area at all, while an ink was received on the irradiated area sufficiently and the recorded image was reproduced on the printing paper.

### Comparative Example 1

A lithographic printing original plate was prepared and recording of image, printing and evaluation were carried out in the same manner as in Example 1, except that the acryloyl morpholine was not added (acryloyl morpholine: 0% based on the amount of the hydrophilic polymer, hydrophilic polymer: 52% based on the amount of the photosensitive resin composition). In order to carry out the printing in good quality, the amount of the fountain solution was required to be as much as 70% of the capacity of the printing press. When the amount of the fountain solution was reduced to 50% of the capacity of the printing press, which is an amount similar to that for PS plates, scumming occurred.

### Comparative Example 2

A lithographic printing original plate was prepared and recording of image, printing and evaluation were carried out in the same manner as in Example 2, except that the amount of the aqueous solution of urea (solid content: 15%) was changed to 120 parts (urea: 23% based on the amount of the hydrophilic polymer, hydrophilic polymer: 49% based on the amount of the photosensitive resin composition). A part of the photosensitive layer was broken away during the printing and evaluation process, and the evaluation can not be accomplished.

### Comparative Example 3

A lithographic printing original plate was prepared and recording of image, printing and evaluation were carried out in the same manner as in Example 5, except that the amount of acryloyl morpholine in the hydrophilic polymer P-2 of the Example 5 was changed to 0. 6g (acryloyl morpholine: 0.4% based on the amount of the hydrophilic polymer, hydrophilic polymer: 57% based on the amount of the photosensitive resin composition). In order to carry out the printing in good quality, the amount of the fountain solution was required to be as much as 70% of the capacity of the printing press. When the amount of the fountain solution was reduced to 50% of the capacity of the printing press, which is an amount similar to that for PS plates, scumming occurred.

### Comparative Example 4

A lithographic printing original plate was prepared and recording of image, printing and evaluation were carried out in the same manner as in Example 5, except that the amount of acryloyl morpholine in the hydrophilic polymer P-2 of Example 5 was changed to 38g (acryloyl morpholine: 21% based on the amount of the hydrophilic polymer, hydrophilic polymer: 57% based on the amount of the photosensitive resin composition). In order to carry out the printing in good quality, the amount of the fountain solution was required to be as much as 75% of the capacity of the printing press. When the amount of the fountain solution was reduced to 50% of the capacity of the printing press, which is an amount similar to that for PS plates, scumming occurred.

**Table**

| Examples | Hydrophili c Polymer Content | Inhibiting Compound | Inhibiting Compound Content (Weight %) | Amount of Fountain Solution (%) | Remarks |
|---|---|---|---|---|---|
| Example 1 | 52 | Acryloyl Morpholine | 15 | 50 | Added in the Resin Composition |
| Example 2 | 52 | Urea | 15 | 50 | Added in the Resin Composition |
| Example 3 | 57 | Acryloyl Morpholine | 5.3 | 50 | Copolymerized with the Hydrophilic Polymer |
| Example 4 | 57 | Acryloyl Morpholine | 5.3 | 50 | Copolymerized with the Hydrophilic Polymer |
| Example 5 | 36 | Acryloyl Morpholine | 5.3 | 50 | Copolymerized with the Hydrophilic Polymer |
| Example 6 | 36 | Acryloyl Morpholine | 1 | 50 | Copolymerized with the Hydrophilic Polymer |
| Example 7 | 36 | I,N-dimethyl methacrylamid | 5.3 | 50 | Copolymerized with the Hydrophilic Polymer |
| Comparative Example 1 | 52 | - | 0 | 70 | Not Added |
| Comparative Example 2 | 49 | Urea | 23 | (Broken Off | Added in the Resin Composition |
| Comparative Example 3 | 57 | Acryloyl Morpholine | 0.4 | 70 | Copolymerized with the Hydrophilic Polymer |
| Comparative Example 4 | 57 | Acryloyl Morpholine | 21 | 75 | Copolymerized with the Hydrophilic Polymer |

### INDUSTRIAL APPLICABILITY

It relates to a photosensitive resin composition for lithographic printing plate and a printing original plate, and more particularly to a photosensitive resin composition for lithographic printing plate and a lithographic printing original plate utilizing a fountain solution. In more detail, it relates to a photosensitive resin composition for lithographic printing plate and a lithographic printing original plate, which is sensitive to a light in near infrared region, which can be handled even in a bright room, on which drawing can directly be made with a laser beam, which does not need operations of development and wiping-off and which is excellent in various printing properties.

## Claims

1. A photosensitive resin composition for lithographic printing plate **characterized by** the fact that the photosensitive resin composition for lithographic printing plate comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound that inhibits hydrogen bond within the molecule and/or between the molecules of the hydrophilic polymer.

2. A photosensitive resin composition for lithographic printing plate **characterized by** the fact that the photosensitive resin composition for lithographic printing' plate comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound represented by the general formula (1). 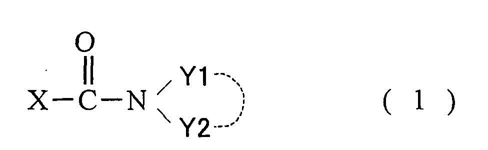 (In the formula, X represents CHR1=CR2- or N(R3) (R4); each of R1, R2, R3 and R4 independently represents hydrogen atom, an alkyl group, an alkoxy group, an aryl group or a heterocyclic group. Y1 and Y2 respectively represent hydrogen atom, an alkyl group, an alkoxy group or an aryl group, Y1 and Y2 can be taken together to form a ring with the nitrogen atom and the ring can contain hetero atoms.)

3. The photosensitive resin composition for lithographic printing plate described in claim 2, wherein at least a part of the compound represented by formula (1) is an N,N-disubstituted (meth)acrylamide compound.

4. The photosensitive resin composition for lithographic printing plate described in claim 2, wherein at least a part of the compound represented by formula (1) is urea.

5. The photosensitive resin composition for lithographic printing plate described in claim 3, wherein the N,N-disubstituted (meth)acrylamide compound has been copolymerized with the hydrophilic polymer.

6. A lithographic printing original plate utilizing a fountain solution and comprising a hydrophilic photosensitive layer **characterized by** the fact that the hydrophilic photosensitive layer is obtained from a photosensitive resin composition for lithographic printing plate that comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound represented by the general formula (1). 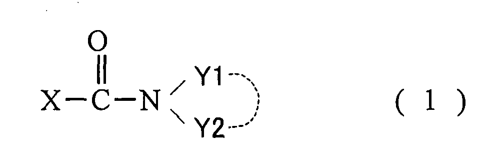 (In the formula, X represents CHR1=CR2- or N(R3)(R4); each of R1, R2, R3 and R4 independently represents hydrogen atom, an alkyl group, an alkoxy group, an aryl group or a heterocyclic group. Y1 and Y2 respectively represent hydrogen atom, an alkyl group, an alkoxy group or an aryl group, Y1 and Y2 can be taken together to form a ring with the nitrogen atom and the ring can contain hetero atoms.)

7. The lithographic printing original plate described in claim 6, wherein the said hydrophilic photosensitive layer has been crosslinked.

8. The lithographic printing original plate described in claim 6, wherein at least a part of the compound represented by formula (1) is an N,N-disubstituted (meth) acrylamide compound.

9. The lithographic printing original plate described in claim 6, wherein at least a part of the compound represented by formula (1) is urea.

10. The lithographic printing original plate described in claim 8, wherein the said N,N-disubstituted (meth)acrylamide compound has been copolymerized with the said hydrophilic polymer.

11. The lithographic printing original plate described in claim 6 **characterized by** the fact that the said hydrophilic resin photosensitive layer has a property that the surface can be converted from hydrophilic to ink-receptive by a irradiation with a light.

12. A lithographic printing plate obtained by irradiating a light on the lithographic printing original plate described in claim 6 thereby converting the surface of the irradiated area to ink-receptive.

13. A lithographic printing original plate utilizing fountain solution and having a hydrophilic resin photosensitive layer, wherein the hydrophilic resin photosensitive layer is obtained from a photosensitive resin composition for lithographic printing plate that comprises not less than 10 % by weight and not more than 90 % by weight of a hydrophilic polymer having at least a hydrophilic group and not less than 0.5 % by weight and not more than 20 % by weight, based on the amount of the hydrophilic polymer, of a compound that inhibits hydrogen bond within the molecule and/or between the molecules of the hydrophilic polymer.
